# EUROPEAN PATENT APPLICATION

(11) **EP 4 625 047 A1**
(43) Date of publication of application: **01.10.2025**
(21) Application number: 24166117.2
(22) Date of filing: 26.03.2024
(51) Int. Cl.: G03F 7/20

(54) **METHOD FOR OPTIMIZING THE EMISSION OF ELECTROMAGNETIC RADIATION OF AN ILLUMINATION SYSTEM OF A PROJECTION EXPOSURE APPARATUS, ILLUMINATION SYSTEM, PROJECTION EXPOSURE APPARATUS**

(71) Applicant: Carl Zeiss SMT GmbH, 73447 Oberkochen (DE); ASML Netherlands B.V., 5504 DR Veldhoven (NL)
(72) Inventor: HARRISON, Kramer Daniel, 5504 DR VELDHOVEN (NL); BOTTER, Michiel, 5504 DR VELDHOVEN (NL); KOCKEROLS, Jean, 5504 DR VELDHOVEN (NL); CORONEL, Joshua, 5504 DR VELDHOVEN (NL); UTINA, Andrei Catalin, 5504 DR VELDHOVEN (NL)
(74) Representative: Raunecker, Klaus Peter

(57) **Abstract**

The invention relates to a method for optimization the emission of electromagnetic radiation (16) of an illumination system (2) of a projection exposure apparatus (1), the illumination system (2) comprising a rotatable collector mirror (31) to optimize the emission, whereas the method is characterized in that the optimization is based on a reflectivity map of the collector mirror (31).

Furthermore, the invention relates to an illumination system (2) comprising a source with a rotatable collector mirror (31), whereas the illumination system (2) is characterized in that the collector mirror (31) is designed in such a way, that the collector mirror (31) can be positioned in an arbitrary angle between 0° and 360° around its longitudinal axis.

## Description

The invention relates to a method for optimizing the emission of electromagnetic radiation of an illumination system of a projection exposure apparatus, an illumination system and a projection exposure apparatus.

Projection exposure apparatuses for semiconductor lithography show a strong dependence on the quality of the illumination of the object plane with regard to their imaging quality. The electromagnetic radiation used for the illumination is generated by an illumination system and a light source, which is referred to hereinafter as the used light source. In the case of EUV lithography, the used light source is a comparatively complex plasma source, with which a plasma that emits electromagnetic radiation in the desired short-wave frequency ranges is generated by means of laser irradiation of tin droplets.

The mirror reflecting part of the used light source, and normally the first mirror reflecting EUV light in the system, is an EUV collector mirror, which collects the EUV light emitted by the plasma and directs it in a concentrated form into the illumination system of the EUV projection exposure apparatus. The radiation generated by the used light source in this case comprises not only radiation of the wavelength of the used light, which in the case of an EUV projection exposure apparatus lies in the range from 5 nm to 20 nm, in particular at 13.5 nm, but also radiation components of other wavelengths, such as for example IR radiation. The IR radiation is a radiation that is emitted by the laser for generating the plasma and is not intended to enter the optics of the illumination system or the projection optical unit, since it otherwise heats up the optical elements, which has adverse effects on the imaging quality.

A collector mirror focuses the emitted radiation of the plasma, the collector mirror usually including a main body, which is produced for example from ceramics or glasses. The collector mirror, like other mirrors used in the apparatus too, also comprises at least one layer system, for example a molybdenum-silicon multi-ply layer, which allows high-precision working of the surface and/or a high reflectivity in the desired spectral range. The layer system often also has the task of filtering out undesired radiation components, such as for example the infrared radiation of the plasma and of the laser. For this purpose, specialized sublayers or grating structures may be incorporated in the coating.

The described coatings of the collector mirror are generally exposed to great loading due to radiation and contamination by tin particles. Furthermore, there are other causes which can lead to a potential degeneration of and/or defects on the reflective surface of the collector mirror. The therefor minimized reflectivity will cause less used light to be emitted to the illumination system and hereafter to the projection optics of the projection exposure apparatus, which decreases throughput, which is one of the most important key performance indicators (KPI) for system power and system performance.

It is also known from the state of the art, as for example the US patent US 10429729 B2 that different areas of the collector mirror contribute different amounts of emitting light reaching the illumination system. Reasons for this are especially a non-uniform impact of EUV-light from the plasma onto the mirror and the fact that different regions of the mirror have different contributions to the system power based on incident angles, optical and mechanical design, gas flow within the system and the fact that apertures in the illumination system or the projection system are clipping of parts of the EUV-light. The non-uniformity of the plasma and the degradation of the collector mirror vary from system to system and also over time.

All constant contributors reducing the system power can be optimized or eliminated during the setup of the projection exposure apparatus, while changes over time can lead to a significant impact on system performance. The above-mentioned US Patent discloses different methods to increase system performance, as optimization of laser beam shaping for irradiation of the tin droplet and rotation of the collector mirror. Instances of degradation or damage to the coating of the collector mirror have been detected by measuring the homogeneity of the far field, which has the disadvantage that the measurement is laborious and leads to an interruption in the production process of the exposure apparatus. Another method for assessing the state of the collector mirror is a visual inspection, the collector mirror having to be removed from the projection exposure apparatus for this.

Furthermore, the German patent application DE 10 2015 201 139 A1 discloses a solution in which a camera records an image of the surface of an optical element and, on the basis of the different intensities of the reflected radiation, draws a conclusion with respect to particles or damaged locations. The size of the particles/damaged locations can be measured by varying the focal plane of the camera and/or the wavelength of the illumination. However, this solution has the disadvantage that a topography of the entire surface can only be determined with a large number of measurements, and consequently a very great effort, and the detection of small unevenness or incipient bubbles can only be detected with difficulty.

The object of the present invention is to provide a method for the detection of anomalies of the topography of a collector mirror and a prediction of a necessary collector exchange.

This object is achieved by a method having the features of independent claim 1. The dependent claims relate to advantageous refinements and variants of the invention.

A method according to the invention for optimization the emission of electromagnetic radiation of an illumination system of a projection exposure apparatus, where the illumination system comprises a rotatable collector mirror to optimize the emission, is characterized in that the optimization is based on a reflectivity map of the collector mirror. The reflectivity map corresponds to an image of the surface of the collector mirror as explained below. The electromagnetic radiation can be EUV-light, in particular at, or near, a wavelength of 13.5 nm.

In particular the reflectivity map can be spatially resolved. This has the advantage, that any change in the surface of the collector mirror can be seen on the reflectivity map. Optimization based on this spatial resolution of reflectivity of the collector mirrors allows the optimization in comparatively greater detail than with pupil measurements as used in the state of the art.

Furthermore, the reflectivity map can be based on an image of a conjugated plane of the surface of the collector mirror. Using the image of a conjugated plane is comparatively easier than generating an image of the surface itself, especially if a fast measurement of the reflectivity map and/or a reflectivity map based on the reflection of the used light of the projection exposure apparatus is wanted.

Besides this the image of the conjugated plane can be based on the image of a pupil plane within the projection exposure apparatus. The conjugated plane is a field plane or near to a field plane.

In particular the pupil plane can be located in the projection optical unit or near wafer level of the projection exposure apparatus. Especially on wafer level the accessibility to position measurement systems or single sensors to measure the pupil plane can be comparatively easy. The wafer can be moved for exposure by a wafer stage, which is designed to move great distances. Furthermore, the wafer stage can be used to carry the measurement system and/or sensors permanently or temporarily.

Furthermore, the image of the pupil plane can be corrected based on optical design properties of the optical elements located between the measurement pupil plane and the conjugated plane of the collector mirror. By using optical design parameters the pathway of single rays or light paths can be recalculated from pupil measurements to the conjugated plane.

In particular the image can be determined based on deconvolution of single rays. For example starting at a pupil measurement near the wafer level, single rays or light paths using different paths through the optical system can be recalculated. Using the single information of each ray the image of the surface of the collector mirror in a conjugated plane can be determined.

In a further embodiment of the method a contribution map of the collector mirror can be used as further input to determine the rotational position of the collector mirror.

The contribution map may include the percentage of contribution of different areas of the collector mirror to the system power. These can be based on incident angles of EUV-light, optical and mechanical design, gas flow within the system and the fact, that apertures in an illumination optical unit and/or a projection optical unit of the projection exposure apparatus may be clipping parts of the EUV-light. Combining the spatially-resolved reflectivity map of the collector mirror with the nominal contribution of areas of the collector mirror by design can advantageously be used in an optimization of the resulting contribution to the system power by adapting the rotational position of the collector mirror. Areas of less reflectivity can be rotated into to areas of less contribution and vice versa to optimize the overall output. Based on the spatial information on reflectivity and the contribution areas no scanning of the surface is necessary to determine the optimum rotational position. The optimum rotational position can be pre-calculated.

In a further embodiment of the method an un-uniform distribution of emission of EUV-light from the plasma is determined as input for determining the optimum rotational position of the collector mirror. Besides the above-mentioned reflectivity map and the contribution map the knowledge of distribution of emission of EUV-light can be used to further optimize the emission of EUV-light from the illumination optical unit and thus the optical system.

An illumination system according to the invention comprises a source with a rotatable collector mirror and is characterized in that the collector mirror is designed in such a way, that the collector mirror can be positioned in an arbitrary angle between 0° and 360° around its longitudinal axis. This bears the possibility to adapt the rotational position of the collector mirror in order to optimize the emission of EUV-light from the collector mirror into the illumination system of the projection exposure apparatus.

Furthermore, the illumination system can comprise a Sagnac Interferometer to control the position of the collector mirror. The Sagnac Interferometer is especially designed for measuring changes in rotational position. Two laser beams are reflected by the identical mirrors, which are arranged in a way, that a rotation of the mirror arrangement leads to a difference of the travel times of the laser beams. This travel time difference is based on the fact, that the laser beam in direction of the rotation of the mirror arrangement takes more time, than the laser beam going against the rotation. This time difference can be detected and is correlated to the change in rotation. In this context, "controlling" is to be understood as detecting rotational movements and, consequently, contributing to the stabilization of the rotational position of the mirror.

In a further embodiment of the invention the illumination system can comprise an additional sensor to detect rotational position of the collector mirror. This sensor should be designed to have an absolute rotational signal and can be used to rotate the collector mirror into the predetermined position as described in the above method. The sensor can therefore especially used during set up of the projection exposure apparatus.

Besides the illumination system can comprise a sensor to detect tilting of the collector mirror. The tilting angle of the collector mirror has an influence on the reflectivity map and the angular distribution of emission of the EUV-light and can be used as an additional input parameter to determine the optimum rotational position of the collector mirror. Furthermore, the tilting of the collector mirror can have an influence on the Sagnac interferometer and can be therefore be used to correct for parasitic measurements offsets.

In a further embodiment of the invention the illumination system can comprise a control to determine the optimum rotational position of collector mirror. The control can determine the optimum position based on the above-mentioned input parameters. Besides the control can position the collector mirror to the predetermined position using an actuator unit and control the position by the position information detected by the Sagnac interferometer.

Furthermore, the control can be connected to a global control of a projection exposure apparatus. This enables the use of more parameters determined within the entire projection exposure apparatus to determine the optimum rotational position. Based on machine learning and big-data based methods and/or algorithms, the influence of basically any parameter determined in the apparatus and correlated with the emission of EUV-light from the collector mirror can be used to optimize the emission of EUV-light over time.

A projection exposure apparatus according to the invention comprises an illumination system of one of the above-mentioned embodiments.

Exemplary embodiments and variants of the invention are explained in more detail below with reference to the drawing, in which:
- Figure 1: schematically shows a meridional section of a projection exposure apparatus for EUV projection lithography,
- Figure 2: shows a first embodiment of the invention,
- Figure 3: a typical reflection map of a collector mirror,
- Figure 4: a graph of correlation between rotational position, tilt of mirror and decentration of plasma; and
- Figure 5: a simulated variation of throughput over rotational position.
With reference to Figure 1, the essential components of a microlithographic projection exposure apparatus 1 are initially described below in exemplary fashion. The description of the basic structure of the projection exposure apparatus 1 and its components are here not understood to be limiting.

An embodiment of an illumination system 2 of the projection exposure apparatus 1 has, in addition to a radiation source 3, an illumination optical unit 4 for illuminating an object field 5 in an object plane 6. In an alternative embodiment, the light source 3 can also be provided as a separate module from the remaining illumination system. In this case, the illumination system does not comprise the light source 3.

A reticle 7 arranged in the object field 5 is exposed. The reticle 7 is held by a reticle holder 8. The reticle holder 8 is displaceable by way of a reticle displacement drive 9, in particular in a scanning direction.

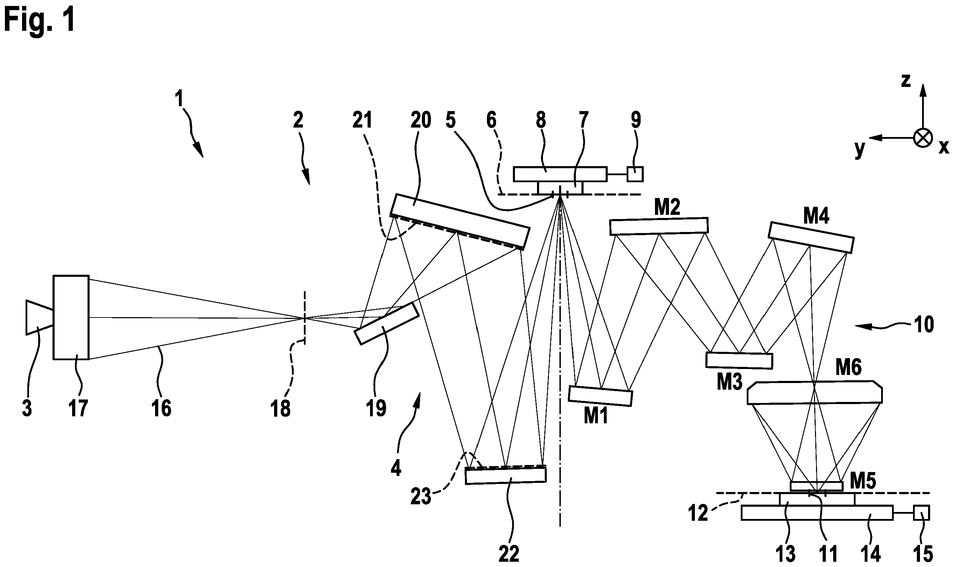

A Cartesian xyz-coordinate system is shown in Figure 1 for explanation purposes. The x-direction runs perpendicularly to the plane of the drawing into the latter. The y-direction runs horizontally and the z-direction runs vertically. The scanning direction extends along the y-direction in Figure 1. The z-direction runs perpendicular to the object plane 6.

The projection exposure apparatus 1 comprises a projection optical unit 10. The projection optical unit 10 serves for imaging the object field 5 into an image field 11 in an image plane 12. The image plane 12 runs parallel to the object plane 6. Alternatively, an angle between the object plane 6 and the image plane 12 that differs from 0° is also possible.

A structure on the reticle 7 is imaged onto a light-sensitive layer of a wafer 13 arranged in the region of the image field 11 in the image plane 12. The wafer 13 is held by a wafer holder 14. The wafer holder 14 is displaceable by way of a wafer displacement drive 15, in particular along the y-direction. The displacement on the one hand of the reticle 7 by way of the reticle displacement drive 9 and on the other hand of the wafer 13 by way of the wafer displacement drive 15 can take place in such a way as to be synchronized with one another.

The radiation source 3 is an EUV radiation source. The radiation source 3 emits, in particular, EUV radiation 16, which is also referred to below as used radiation, illumination radiation or illumination light. In particular, the used radiation has a wavelength in the range between 5 nm and 30 nm. The radiation source 3 can be a plasma source, for example an LPP source (Laser Produced Plasma) or GDPP source (Gas Discharged Produced Plasma). It can also be a synchrotron-based radiation source. The radiation source 3 can be a free electron laser (FEL).

The illumination radiation 16 emerging from the radiation source 3 is focused by a collector 17. The collector 17 may be a collector with one or more ellipsoidal and/or hyperboloidal reflection surfaces. The illumination radiation 16 may be incident on the at least one reflection surface of the collector 17 with grazing incidence (GI), that is to say at angles of incidence of greater than 45°, or with normal incidence (NI), i.e. at angles of incidence of less than 45°. The collector 17 can be structured and/or coated, firstly, for optimizing its reflectivity for the used radiation and, secondly, for suppressing extraneous light.

Downstream of the collector 17, the illumination radiation 16 propagates through an intermediate focus in an intermediate focal plane 18. The intermediate focal plane 18 may represent a separation between a radiation source module, having the radiation source 3 and the collector 17, and the illumination optical unit 4.

The illumination optical unit 4 comprises a deflection mirror 19 and, arranged downstream thereof in the beam path, a first facet mirror 20. The deflection mirror 19 may be a plane deflection mirror or, alternatively, a mirror with a beam-influencing effect that goes beyond the purely deflecting effect. As an alternative or in addition thereto, the deflection mirror 19 can be embodied as a spectral filter separating a used light wavelength of the illumination radiation 16 from extraneous light having a wavelength that deviates therefrom. If the first facet mirror 20 is arranged in a plane of the illumination optical unit 4 that is optically conjugate to the object plane 6 as a field plane, it is also referred to as a field facet mirror. The first facet mirror 20 comprises a multiplicity of individual first facets 21, which are also referred to below as field facets. Some of these facets 21 are shown in Figure 1 only by way of example.

The first facets 21 may be embodied as macroscopic facets, in particular as rectangular facets or as facets with an arcuate peripheral contour or a peripheral contour of part of a circle. The first facets 21 may be embodied as plane facets or alternatively as convexly or concavely curved facets.

As known for example from DE 10 2008 009 600 A1, the first facets 21 themselves may also be composed in each case of a multiplicity of individual mirrors, in particular a multiplicity of micromirrors. The first facet mirror 20 may in particular be formed as a microelectromechanical system (MEMS system). For details, reference is made to DE 10 2008 009 600 A1.

Between the collector 17 and the deflection mirror 19, the illumination radiation 16 travels horizontally, that is to say along the y-direction.

In the beam path of the illumination optical unit 4, a second facet mirror 22 is arranged downstream of the first facet mirror 20. If the second facet mirror 22 is arranged in a pupil plane of the illumination optical unit 4, it is also referred to as a pupil facet mirror. The second facet mirror 22 may also be arranged at a distance from a pupil plane of the illumination optical unit 4. In this case, the combination of the first facet mirror 20 and the second facet mirror 22 is also referred to as a specular reflector. Specular reflectors are known from US 2006/0132747 A1, EP 1 614 008 B1 and US 6,573,978.

The second facet mirror 22 comprises a plurality of second facets 23. In the case of a pupil facet mirror, the second facets 23 are also referred to as pupil facets.

The second facets 23 can likewise be macroscopic facets, which can, for example, have a round, rectangular or hexagonal boundary, or alternatively be facets composed of micromirrors. In this regard, reference is likewise made to DE 10 2008 009 600 A1.

The second facets 23 may have planar or alternatively convexly or concavely curved reflection surfaces.

The illumination optical unit 4 consequently forms a twice-faceted system. This basic principle is also referred to as a honeycomb condenser (fly's eye integrator).

It may be advantageous to arrange the second facet mirror 22 not exactly in a plane that is optically conjugate to a pupil plane of the projection optical unit 10. In particular, the pupil facet mirror 22 can be arranged so as to be tilted relative to a pupil plane of the projection optical unit 7, as is described, for example, in DE 10 2017 220 586 A1.

The individual first facets 21 are imaged into the object field 5 with the aid of the second facet mirror 22. The second facet mirror 22 is the last beam-shaping mirror or else, in fact, the last mirror for the illumination radiation 16 in the beam path before the object field 5.

In a further embodiment of the illumination optical unit 4 that is not shown, a transmission optical unit contributing in particular to the imaging of the first facets 21 into the object field 5 may be arranged in the beam path between the second facet mirror 22 and the object field 5. The transmission optical unit may have exactly one mirror or else alternatively two or more mirrors, which are arranged one behind the other in the beam path of the illumination optical unit 4. The transmission optical unit may in particular comprise one or two normal-incidence mirrors (NI mirrors) and/or one or two grazing-incidence mirrors (GI mirrors).

In the embodiment shown in Figure 1, the illumination optical unit 4 has exactly three mirrors downstream of the collector 17, specifically the deflection mirror 19, the field facet mirror 20 and the pupil facet mirror 22.

The deflection mirror 19 can also be dispensed with in a further embodiment of the illumination optical unit 4, and so the illumination optical unit 4 can then have exactly two mirrors downstream of the collector 17, specifically the first facet mirror 20 and the second facet mirror 22.

As a rule, the imaging of the first facets 21 into the object plane 6 by means of the second facets 23 or using the second facets 23 and a transmission optical unit is only approximate imaging.

The projection optical unit 10 comprises a plurality of mirrors Mi, which are consecutively numbered in accordance with their arrangement in the beam path of the projection exposure apparatus 1.

In the example illustrated in Figure 1, the projection optical unit 10 comprises six mirrors M1 to M6. Alternatives with four, eight, ten, twelve or any other number of mirrors Mi are similarly possible. The penultimate mirror M5 and the last mirror M6 each have a through opening for the illumination radiation 16. The projection optical unit 10 is a double-obscured optical unit. The projection optical unit 10 has an image-side numerical aperture which is greater than 0.3 and which can also be greater than 0.6 and can, for example, be 0.7 or 0.75.

Reflection surfaces of the mirrors Mi can be embodied as free-form surfaces without an axis of rotational symmetry. Alternatively, the reflection surfaces of the mirrors Mi may be designed as aspherical surfaces with exactly one axis of rotational symmetry of the reflection surface form. Just like the mirrors of the illumination optical unit 4, the mirrors Mi may have highly reflective coatings for the illumination radiation 16. These coatings may be designed as multilayer coatings, in particular with alternating layers of molybdenum and silicon.

The projection optical unit 10 has a large object image offset in the y-direction between a y-coordinate of a centre of the object field 5 and a y-coordinate of the centre of the image field 11. In the y-direction, this object-image offset can be approximately the same size as a z-distance between the object plane 6 and the image plane 12.

In particular, the projection optical unit 10 may have an anamorphic form. In particular, it has different imaging scales βx, βy in the x- and y-directions. The two imaging scales βx, βy of the projection optical unit 10 preferably lie at (βx, βy) = (+/- 0.25, /+-0.125). A positive imaging scale β means imaging without an image reversal. A negative sign for the imaging scale β means imaging with an image reversal.

The projection optical unit 10 consequently leads to a reduction in size with a ratio of 4:1 in the x-direction, that is to say in a direction perpendicular to the scanning direction.

The projection optical unit 10 leads to a reduction in size of 8:1 in the y-direction, that is to say in the scanning direction.

Other imaging scales are similarly possible. Imaging scales with the same sign and the same absolute value in the x-direction and y-direction are also possible, for example with absolute values of 0.125 or of 0.25.

The number of intermediate image planes in the x-direction and in the y-direction in the beam path between the object field 5 and the image field 11 may be the same or, depending on the embodiment of the projection optical unit 10, may differ. Examples of projection optical units with different numbers of such intermediate images in the x- and y-directions are known from US 2018/0074303 A1.

In each case one of the pupil facets 23 is assigned to exactly one of the field facets 21 for forming in each case an illumination channel for illuminating the object field 5. In particular, this can yield illumination according to the Köhler principle. The far field is decomposed into a multiplicity of object fields 5 with the aid of the field facets 21. The field facets 21 produce a plurality of images of the intermediate focus on the pupil facets 23 respectively assigned thereto.

The field facets 21 are imaged, in each case by way of an assigned pupil facet 23, onto the reticle 7 in a manner such that they are superposed on one another for the purposes of illuminating the object field 5. The illumination of the object field 5 is in particular as homogeneous as possible. It preferably has a uniformity error of less than 2%. The field uniformity can be achieved by way of the superposition of different illumination channels.

The illumination of the entrance pupil of the projection optical unit 10 can be defined geometrically by way of an arrangement of the pupil facets. The intensity distribution in the entrance pupil of the projection optical unit 10 can be set by selecting the illumination channels, in particular the subset of the pupil facets which guide light. This intensity distribution is also referred to as illumination setting.

A likewise preferred pupil uniformity in the region of defined illuminated sections of an illumination pupil of the illumination optical unit 4 can be achieved by a redistribution of the illumination channels.

Further aspects and details of the illumination of the object field 5 and in particular of the entrance pupil of the projection optical unit 10 are described below.

In particular, the projection optical unit 10 may have a homocentric entrance pupil. The latter may be accessible. It may also be inaccessible.

The entrance pupil of the projection optical unit 10 cannot be exactly illuminated using the pupil facet mirror 22 on a regular basis. In the case of imaging the projection optical unit 10 in which the centre of the pupil facet mirror 22 is telecentrically imaged onto the wafer 13, the aperture rays often do not intersect at a single point. However, it is possible to find an area in which the distance of the aperture rays determined in pairs becomes minimal. This area represents the entrance pupil or an area in real space that is conjugate thereto. In particular, this area has a finite curvature.

It may be that the projection optical unit 10 has different positions of the entrance pupil for the tangential beam path and for the sagittal beam path. In this case, an imaging element, in particular an optical component part of the transmission optical unit, should be provided between the second facet mirror 22 and the reticle 7. With the aid of this optical element, the different position of the tangential entrance pupil and the sagittal entrance pupil can be taken into account.

In the arrangement of the components of the illumination optical unit 4 illustrated in Figure 1, the pupil facet mirror 22 is arranged in an area conjugate to the entrance pupil of the projection optical unit 10. The field facet mirror 20 is arranged in tilted fashion with respect to the object plane 6. The first facet mirror 20 is arranged in tilted fashion with respect to an arrangement plane defined by the deflection mirror 19.

The first facet mirror 20 is arranged so as to be tilted in relation to an arrangement plane defined by the second facet mirror 22.

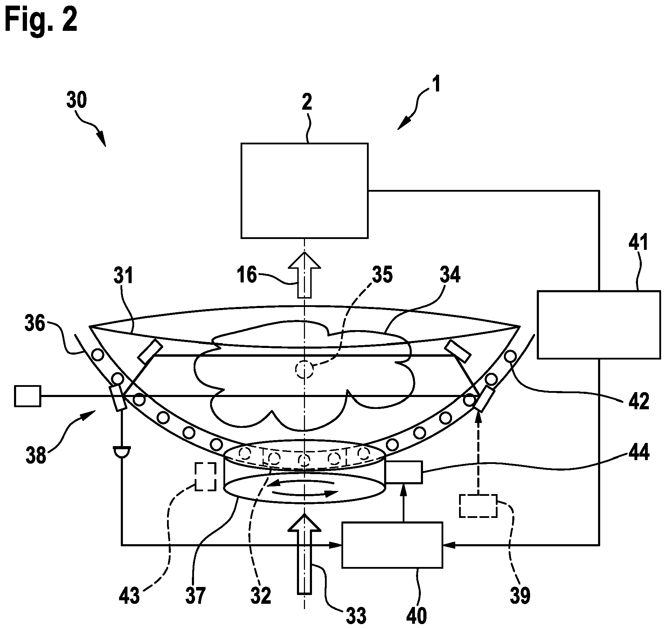

Figure 2 shows an inventive source module 30, which corresponds to a source module 3, 17 of the projection exposure apparatus 1 described in figure 1. The source module 30 comprises a collector mirror 31 with a recess 32. The recess 32 allows a laser beam 33 to irradiate onto a tin droplet 35 for generating an EUV-light 16 emitting plasma 34.

The collector mirror 31 is mounted into a holding frame 36, which is mounted onto a rotation stage 37. The rotation stage 37 can rotate the holding frame 36 and thus the mirror 31 in a total of 360°. Due to mechanical constraints and several connections between the source module 30 and its surrounding modules of the projection exposure apparatus 1 (Figure 1), as for example power lines, signal lines and/or fluid lines, the range of 360° will be realized by a rotation of 180° in two directions from a defined starting point. In the embodiment shown in figure 2 the fluid lines will supply fluid channels 42 located in the space between the holding frame 36 and the collector mirror 31 with fluid. The fluid channels 42 are connected to the collector mirror 31 and will cool and/or heat the collector mirror 31 to stabilize the temperature of the collector mirror 31 during system use.

Further embodiments of the collector mirrors 31 may comprise fluid channels within the body of the collector mirror 31, in which case the rotation stage 37 could also be connected directly to the collector mirror 31.

The rotation stage 37 comprises an actuator unit 44 in order to rotate the holding frame 36. The rotational position during set up of the projection exposure apparatus 1 will be defined by measuring a leading key performance parameter for optimizing the system, in particular throughput, which is an equivalent of system power. Once the optimal angular position of the holding frame 36 is reached, a Sagnac interferometer 38 is used as a sensor for position control of the holding frame 36. The Sagnac interferometer 38 can precisely measure the absolute rotational velocity of the holding frame and therefore is especially suitable to control the exact position of the holding frame 36 after adjustment.

In further embodiments a second sensor 43 can be feasible to detect the rotational position of the collector mirror 31 during set up. The sensor 43 will mainly be used during set up of the projection exposure apparatus 1, but may simplify the positioning of the holding frame 36 by reducing the amount of the usually time consuming through put measurements.

Furthermore, a tilt sensor 39 can be arranged in the source module 30 to detect the tilt of the mirror 31. The tilt measurement can be used during set up of the system and during operation. During set up it can be used to support manual alignment of the collector mirror 31 to the plasma 34 and the illumination system 2 (figure 1). During operation a detected change of tilt may be used to correct for parasitic measurement errors of the Sagnac interferometer 38, which is sensitive for change of tilting angles.

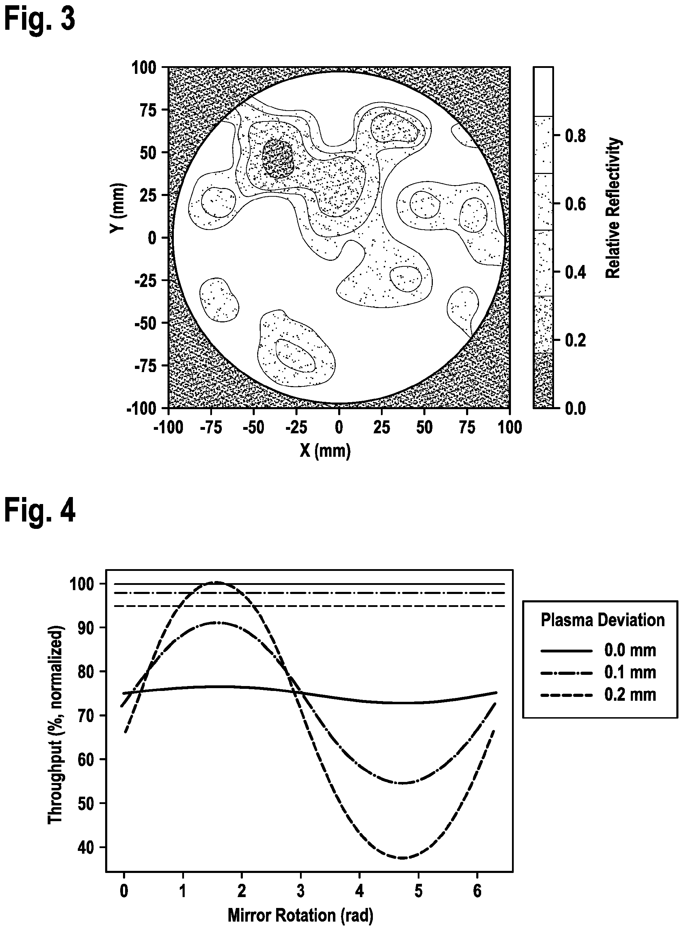

The source module 30 furthermore comprises a control 40, which is connected to the actuator unit 44 of the rotation stage 37, the Sagnac interferometer 38 and to the global control 41 of the projection exposure apparatus 1 described in figure 1. The control 40 therefore can access the overall system performance, any other single or combined performance parameters detected within the apparatus 1. Parameters for example can be key performance indicators like throughput or uniformity of critical dimension or performance parameters of the source unit 30 itself, like a reflectivity map of the collector mirror 31 as shown in figure 3 or a distribution of the emitted EUV-light 16 from the plasma 34.

The source unit 30 is adjusted during setup of the projection exposure apparatus 1, while the position and distribution of EUV-light 16 of the plasma 34 as well as the position and orientation of the collector mirror 31 is adjusted for maximum system power, which is mainly based on the quantity of the emitted EUV-light 16 from the collector mirror into the illumination system 2.

During use of the projection exposure apparatus 1 the system power is monitored continuously. In the case of changes in system power the control 40 determines if a change in rotational position of the collector mirror 31 will improve system power. Possible improvement is based on any contributing parameter, but mainly be based on a reflectivity map of the collector mirror 31 as will be shown in figure 3, the distribution of the emitted EUV-Light 16 from the plasma 34 and the knowledge of more and less contributing areas of the collector mirror 31. Further the mechanical and optical design has an influence on the system power, which is influenced by preferred angles of incident of the EUV-light 16 into the illumination optical unit 4 (figure 1) and possible clipping by apertures or else within the illumination optical unit 4 or the projection optical unit 10 (figure). In the case of a possible improvement the control 40 adapts the rotational orientation of the collector mirror 31.

The possibility of rotating the collector mirror 31 has the advantage to continuously ensure emitting the EUV-light 16 into the illuminations optical unit 4 ensuring maximum system power for the use of imaging structures onto the wafer, which can be seen as leading to a maximum throughput. It is self-explanatory, that in the case of other key performance indicators running out of specification it may be necessary to settle for less than maximum power of EUV-light 16 in favor of other key performance indicators as uniformity of critical dimensions.

The time for correcting the rotational position of the collector mirror 31 during use of the projection exposure apparatus 1 is less critical than for other manipulators and may take seconds. Therefore corrections usually will only be performed in between lots (< 20sec.) or during daily or weekly maintenance (< couple minutes).

Figure 3 shows an arbitrary normalized reflectivity profile of a collector mirror 31, as used as one of the main input parameters of the control 40 (figure 2) to optimize system power by adjusting the rotational position of the collector mirror 31, whereby darker areas are less reflective and lighter ones are more reflective. A reflective profile like shown in the figure can be determined by a measurement system within the projection exposure apparatus 1 (figure 1). Based on a pupil plane measurement near wafer level, information on the optical design of the projection optic and the illumination system, including optical elements M1-M6, 19, 20, 21 (Figure 1) are used to determine an image of the surface of the collector mirror 31 at a conjugated far field plane. The conjugated plane is close to the collector mirror 31 and in direction of light after the intermediate focal plane 18 (figure 1) of the source. Strictly speaking, this image is an image of the surface of the collector mirror 31 and not an intensity distribution, which is usually measured in the pupil of a system. Information on the optical design and the influence of the optical elements, e.g. obtained by calibration measurements of the projection optical unit 10 and the illumination optical unit 4 (see figure 1), is used to deconvolute the information obtained in the pupil plane to obtain the image of the surface of the collector mirror 31. Thereby using different path of light rays through the system to determine the image in the conjugated plane from the pupil measurement. Therefore the measurement system detects several different points in the pupil plane, whereas the number of points can vary depending on the level of resolution needed, from some ten to up to several thousand points. The image of the surface of the collector mirror 31 at the conjugated plane corresponds to a spatially resolved reflectivity map of the surface of the collector mirror 31. Differences due to the optical imaging between the actual surface of the collector mirror 31 and the conjugated plane can be neglected. Furthermore the accuracy of the measurement can be increased performing the measurement at different illumination settings, allowing to detect effects from projection optical unit 10 or illumination optical unit 4 in more detail, by comparison of the determined spatially resolved reflectivity maps. The measurement can be performed e.g. between the exposure of individual wafers, enabling a continuous optimization of the emitted EUV-light 16 from the collector mirror 31 into the illumination optical unit 4 (figure 1) of the projection exposure apparatus 1 by adapting the rotational position of the collector mirror 31.

Besides the spatially resolved two-dimensional reflectivity map a contribution map of the collector mirror 31 based on the contribution of different areas of the collector mirror 31 to the system power based on incident angles, optical and mechanical design, gas flow within the system and the fact, that apertures in the illumination optical unit 4 and/or the projection optical unit 10 may be clipping parts of the EUV-light 16, is determined. Given the above-mentioned knowledge of non-uniform impact of EUV-light 16 from the plasma 34 onto the collector mirror 31, the reflectivity map and the contribution map the control 40 can determine the best possible rotational angle for maximum system power. The system power will be monitored during the rotation to support finding the optimum rotational position.

Besides the above-described measured information there are multiple other parameters of the projection exposure apparatus 1, which can be used as an input for calculating the optimum rotational position for maximizing the emitted EUV-light 16 into the illumination optical system 4. This information used can range from plasma energies measured near the collector mirror, over radiation energy sensors on reticle level 6 (Figure 1) to current positions of adjustable components and/or optical elements of the projection exposure apparatus, to name a few. Machine learning algorithms can also be used to improve rotational position of the collector mirror.

Figure 4 shows the correlation between the rotational position of a collector mirror 31 as described in figure 2, and the tilt of the collector mirror 31 with respect to the source for different values of deviation of the plasma 34 from its nominal position. The source in this case in fact is the position and incident of the laser beam 33 hitting the tin droplet 35 within the collecting mirror 33.

The rotational stage 37 of the source module 30 has the advantage that remaining misalignments of the source to the collector mirror 31 can be corrected or at least minimized using the above information and/or support adjusting the source to the collector mirror 31 taking also tolerances of the mirror 31 and the rotational stage 31 into account.

The knowledge can also be used for diagnostic of the source module 30 during maintenance within the system, by comparing measurements with simulations, which may lead to valuable hints on possible misalignment of source and/or collector mirror 31.

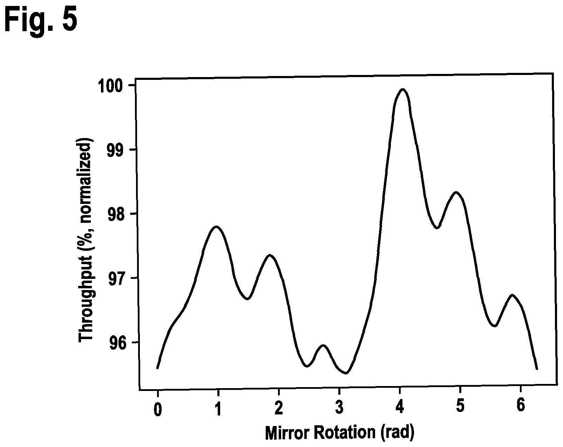

Figure 5 shows an exemplary curve of the correlation of rotation angle of the collector mirror 31 (Figure 2) and the system performance as represented by the throughput of the projection exposure system 1 in a graph. Based on this graph it can be shown how big the difference of system performance in respect to the rotational position of the collector mirror 31 can be, showing the advantage of the invention. The difference of throughput of the projection exposure apparatus 1 therefore can be up to 5%, depending on the rotational position of the collector mirror 31.

Beside the benefit of increasing the throughput the system performance can be kept within specification. Natural degradation of the reflectivity of the collector mirror can be corrected by rotating areas with less degradation into areas of great contribution to the overall system performance on the collector mirror 31, resulting in a significant extension of the service life of the projection exposure apparatus 1, which advantageously improves cost of ownership.

### List of reference signs

- 1: Projection exposure apparatus
- 2: Illumination system
- 3: Radiation source
- 4: Illumination optical unit
- 5: Object field
- 6: Object plane
- 7: Reticle
- 8: Reticle holder
- 9: Reticle displacement drive
- 10: Projection optical unit
- 11: Image field
- 12: Image plane
- 13: Wafers
- 14: Wafer holder
- 15: Wafer displacement drive
- 16: EUV radiation
- 17: Collector
- 18: Intermediate focal plane
- 19: Deflection mirror
- 20: Facet mirror
- 21: Facets
- 22: Facet mirror
- 23: Facets
- 30: Source module
- 31: collector mirror
- 32: recess for laser
- 33: laser beam
- 34: plasma
- 35: tin droplet
- 36: holding frame
- 37: rotation stage
- 38: Sagnac interferometer
- 39: tilt sensor
- 40: source control unit
- 41: global control
- 42: fluid channels
- 43: rotational sensor
- 44: actuator unit

## Claims

1. Method for optimization the emission of electromagnetic radiation (16) of an illumination system (2) of a projection exposure apparatus (1), the illumination system (2) comprising a rotatable collector mirror (31) to optimize the emission,
**characterized in that**,
the optimization is based on a reflectivity map of the collector mirror (31).

2. Method according to claim 1,
**characterized in that**,
the reflectivity map is spatially resolved.

3. Method according to claim 1 or 2,
**characterized in that**,
the reflectivity map is based on an image of a conjugated plane of the surface of the collector mirror (31).

4. Method according to claim 3,
**characterized in that**,
the image of the conjugated plane is based on the image of a pupil plane within the projection exposure apparatus (1).

5. Method according to claim 4,
**characterized in that**,
the pupil plane is located in the projection optical unit (10) or on wafer level (12) of the projection exposure apparatus (1).

6. Method according to claim 4 or 5,
**characterized in that**,
the image of the pupil plane is corrected based on optical design properties of the optical elements (Mx) located between the measurement pupil plane and the conjugated plane of the collector mirror (31).

7. Method according to claims 3 to 6,
**characterized in that**,
the image is determined based on deconvolution of single rays.

8. Method according to one of the preceding claims,
**characterized in that**,
a contribution map of the collector mirror (31) is used as further input to determine the rotational position of the collector mirror (31).

9. Method according to one of the preceding claims,
**characterized in that**,
un-uniform distribution of emission of electromagnetic radiation (16) from the plasma (34) is determined as input for determining the optimum rotational position of the collector mirror (31).

10. Illumination system (2) comprising a source with a rotatable collector mirror (31),
**characterized in that**
the collector mirror (31) is designed in such a way, that the collector mirror (31) can be positioned in an arbitrary angle between 0° and 360° around its longitudinal axis.

11. Illumination system (2) according to claim 10,
**characterized in that**,
the illumination system (2) comprises a Sagnac Interferometer (38) to control the position of the collector mirror (31).

12. Illumination system (2) according to claim 11,
**characterized in that**,
the illumination system (2) comprises an additional sensor (43) to detect rotational position of the collector mirror (31).

13. Illumination system (2) according to one of the claims 10 to 12, **characterized in that**,
it comprises a sensor (39) to detect tilting of the collector mirror (31).

14. Illumination system (2) according to one of the claims 10 to 13, **characterized in that**,
it comprises a control (40) to determine the optimum rotational position of collector mirror (31) .

15. Illumination system (2) according to claim 14,
**characterized in that**,
the control (40) is connected to global control of a projection exposure apparatus (1).

16. Projection exposure apparatus (1) comprising an illumination system (2) according to one of the claims 10 to 15.
